# EUROPEAN PATENT APPLICATION

(11) **EP 2 015 449 A1**
(43) Date of publication of application: **14.01.2009**
(21) Application number: 07112477.0
(22) Date of filing: 13.07.2007
(51) Int. Cl.: H03H 9/10

(54) **Packaging for piezoelectric resonator**

(71) Applicant: ETA SA Manufacture Horlogère Suisse, 2540 Grenchen (CH)
(72) Inventor: Dalla Piazza, Silvio, 2610 St-Imier (CH)
(74) Representative: Ravenel, Thierry Gérard Louis

(57) **Abstract**

The invention concerns a package comprising a case (10) for receiving a piezoelectric resonator (11), including a main part (12) with a bottom (13) and sides (14), in which said resonator shall be mounted and a cover (26) fixed to said main part closing said case, wherein the main part and the cover are both made of silicon.

## Description

### FIELD OF INVENTION

The present invention concerns packaging for piezoelectric resonators and more particularly for resonators of small dimensions which are most often used for making frequency generators in particular for portable electronic equipment, in numerous fields such as horology, information technology, telecommunications and the medical field.

### BACKGROUND OF THE INVENTION

Such packaging for quartz or piezoelectric resonators of small dimensions are of two different kinds in the prior art. A first kind of packaging concerns metal cases, which are not always available in SMD (Surface Mounted Device) version, and whose minimal size is limited by technology. A second kind of packaging concerns ceramics cases, which are SMD, but whose size is limited by the technology of production as well as the tolerances of manufacturing.

In front of the increasingly pressing request of the market, smaller sizes of SMD package are required, as well as stronger resistance to the higher temperatures of reflow soldering. Above cited kinds of metallic or ceramic cases do not allow anymore to manufacture satisfying packaging for such small resonators.

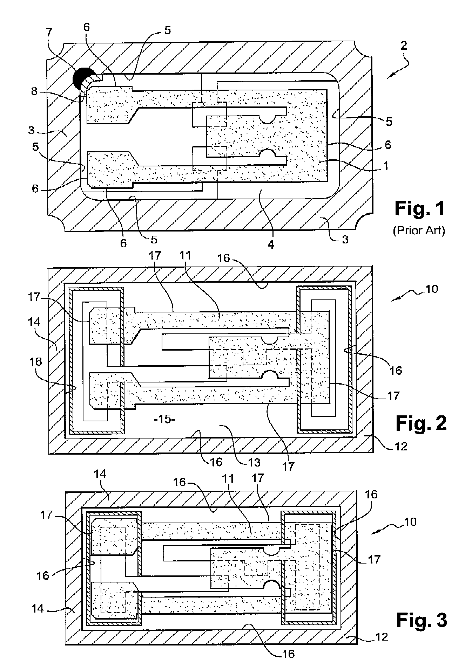

Thus according to existing techniques, for a given dimension of the piezoelectric resonator, the overall size of the packaging will be either too large or too close to the resonator edges with greater risks of losses due to the tolerances of manufacturing. For instance as shown in Figure 1, for a resonator 1 having a length size of about 1,5mm and a width size of about 0,65mm, a ceramic package 2 according to the prior art presents an external length size of at least 2mm and external width size of at least 1,2mm. Since the thickness of the package walls 3 are about 0,2mm, the cavity 4 inside has therefore a length size of 1,6mm and a width size of about 0,8mm. With the traditional manufacturing techniques, dimensions may be obtained with a precision of about 0,12mm, consequently the internal sides 5 of the main part 2 will be very close to the resonator edges 6 especially in the corner 7 where a connection traverses the package 2 to make contact with the outside. This connection inevitably causes some leakages 8 that may short-circuit the resonator electrodes (not represented). The other possibility, which consists in manufacturing wider packages, is not the expected solution to miniaturization issues.

### SUMMARY OF THE INVENTION

The main goal of the present invention is to overcome the aforecited drawbacks by providing a package which combines both advantages, namely better dimensional tolerances, coming from manufacturing technology, and the possibility of directly using material of the cover or lid to make a sealing withstanding appreciably higher final assembly temperature.

For that purpose, according to a first aspect of the invention, it concerns a package for receiving a piezoelectric resonator, including a main part with a bottom and sides, in which said resonator shall be mounted and a cover fixed to said main part closing said case, wherein the main part and the cover are both made of silicon.

According to an advantageous variant, the silicon main part is manufactured by using a photolithographic process and preferably etched by Deep Reactive Ion Etching.

Use of silicon allows manufacturing the main part of the package with small and accurate manufacturing limits. This better dimensional tolerance especially results from the use of a semiconductor photolithographic process and an etching technique such as DRIE (Deep Reactive Ion Etching), where the inner corners are not rounded. Thus for given external dimensions of the package, thanks to the previous point a larger cavity may be obtained, that is favourable for the resonator mounting conditions within the package.

According to another advantageous variant, a heat sealing is directly done between the cover and the main part by an adequate eutectic of a metal and silicon, said adequate eutectic being preferably an alloy of gold and silicon. Use of thin layers of gold for sealing allows direct application of a lid cover of silicon, and optimization of the vacuum thermal profile with local creation of an eutectic Au-Si. The gold layer can either be placed on the lid or on the main part of the package.

According to another advantageous variant, an anti-diffusion layer is coated under this gold layer. This anti-diffusion layer avoids diffusion of the eutectic within the silicon forming the main part or the lid.

According to a second aspect, the invention concerns a component comprising a package according to the first aspect and a piezoelectric resonator mounted in this package.

According to a third aspect, the invention concerns an assembly of two silicon wafers comprising a first wafer in which is manufactured a predetermined number of hollowed main parts for receiving piezoelectric resonators, each hollowed main part including a bottom and sides, in which a resonator shall be mounted, and a second wafer forming a cover for each hollowed main part, wherein the main parts and the covers form closed packages. Such an assembly is highly valuable for making only in once several packages according to the first aspect.

According to a fourth aspect, the invention concerns a method for manufacturing a package for a piezoelectric resonator, comprising the steps of (i) forming in a silicon substrate a main part including a bottom and sides by a photolithographic process and silicon etching, (ii) coating portions of the main part with metal-plated electrodes, (iii) forming in another silicon substrate a cover, (iv) assembling said main part and said cover with an adequate eutectic of a metal and silicon.

According to an advantageous variant of this method, the etching process used is Deep Reactive Ion Etching.

According to another advantageous variant of the fourth aspect, the method further comprises the step of mounting a piezoelectric resonator in contact with the metal-plated electrodes prior to assembly the cover with the main part.

According to another advantageous variant, the method further comprises the step of coating an anti-diffusion layer on the sides of the main part or lid below said eutectic.

According to a fifth aspect, the invention concerns a method for manufacturing packages including piezoelectric resonator mounted inside, comprising the steps of (i) forming in a first silicon wafer a predetermined number of hollowed main parts including a bottom and sides by a photolithographic process and silicon etching; (ii) coating portions of the main parts with metal-plated electrodes; (iii) mounting a piezoelectric resonator in each hollowed main parts in contact with the metal-plated electrodes; (iv) forming in another silicon wafer, a cover for each hollowed main part; (v) assembling said predetermined number of hollowed main parts and said cover with an adequate eutectic of a metal and silicon; (vi) cutting adequately said first and second assembled silicon wafers within sides of the main parts to form said predetermined number of packages including a piezoelectric resonator mounted inside.

### BRIEF DESCRIPTION OF THE DRAWINGS

Other features and advantages of the invention will appear upon reading the following description which refers to the annexed drawings in which:
- Figure 1 is a top and cut view of an opened package according to the prior art;
- Figure 2 is a top and cut view of an opened package according to an embodiment of the invention;
- Figure 3 is a top and cut view of an opened package according to another embodiment of the invention;
- Figure 4 is a top view of the main part of a case according to another embodiment of the invention;
- Figure 5 is a cut view of the case represented in Figure 4 along the A-A axis;
- Figures 6a-6f are the steps of a serial manufacturing process of packages according to a preferred embodiment of the invention.

### DETAILED DESCRIPTION OF THE INVENTION

The present invention will now be described by way of non limiting examples in relation with Figure 2 to 6. For ease of comprehension of the following description, it should be understood by package the combination of a case containing a piezoelectric resonator.

Figure 2 is a top and cut view of an opened package 10 according to a first embodiment of the invention. The package comprises a piezoelectric resonator 11 mounted in a case 12. The piezoelectric resonator 11 shown in Figure 2 is a tuning fork resonator having a central arm forming a linking base with the case 12. Nevertheless, it is obviously understood that any other kind of traditional resonators, e.g. tuning fork without a central arm, is also adapted to be mounted within the case 12 which dimensions are adequately modified.

The case 12 includes a main part with a bottom 13 and sides 14, forming a cavity 15 in which the resonator 11 is mounted and a cover (not shown on this view) fixed to the main part and closing the case. The present case 12 is remarkable in that both the main part and the cover are made of silicon. Thus, thickness of the sides walls are manufactured with high accuracy by using a photolithographic process and silicon etching, so that either the inside cavity 15 is bigger or the overall size of the case (cf. Figure 3) can be reduced for a same resonator. Preferably, the etching process used is Deep Reactive Ion Etching (DRIE).

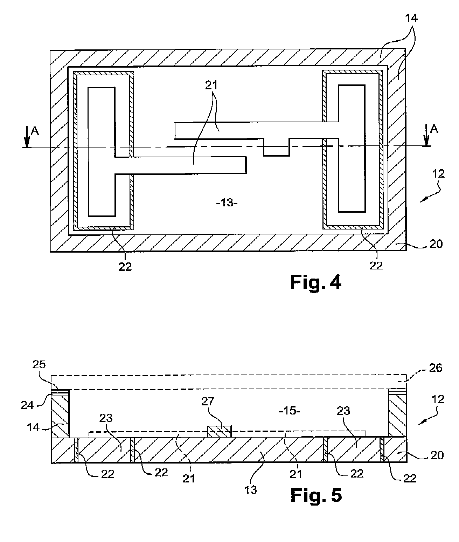

For instance in Figure 2, the outside size of the case 12 has been chosen identical to the one presented in relation with the prior art in Figure 1. Use of silicon along with the use of a photolithographic process for manufacturing such a resonator case allows reducing the tolerances of manufacture. Thus, in this example the remaining space between the inner faces 16 of the case and corresponding facing edges 17 of the resonator is much wider than in the prior art. Consequently, risks of short-circuits as well as obstruction to vibrations of the resonator are avoided. Although electrodes are represented for sake of completeness, related advantages will be more detailed in relation with Figure 4.

Referring now to Figure 3, it shows a top and cut view of an opened package 10 according to another embodiment of the invention similar to the one presented in Figure 2. Same numerical references have been kept for similar elements. In Figure 3, the resonator 11 size remains the same. However, as the tolerances of manufacture are well controlled with the use of a photolithographic process, such tolerances being in the order of a few microns accuracy, inner faces 16 of the sides 14 can be manufactured so as to be really close to the resonator edges 17, so that the overall size of the case 12 is greatly reduced with less risk of short-circuits between electrodes as occurred in the prior art.

Figure 4 is a top view of the main part of the case without resonator according to the embodiment already illustrated in Figure 2. The main part 20 of case 12 includes a bottom 13 and sides 14 forming a cavity (see figure 5) in which the resonator shall be mounted. A cover (not shown on this view) is fixed to the main part for closing the case. In order to insure connection of the resonator electrodes with the inside of the case, the cavity is coated with conduction deposits 21, such as gold deposits. In order to avoid short circuit between the gold deposit and the case made of silicon, special isolation structures 22 are arranged through the bottom 13. These isolation structures are made with dielectrics which share the silicon bottom in at least two different potentials, one being set inside the dielectric isolation structure and the other being set around the dielectric isolation structure. Further with such isolation structure 22, there is no more need to pass through a corner of the case to make connections with the outside.

Still considering Figure 4, it is to be noted that the upper faces of the sides 14 forming the periphery of the case is coated with a specific proportion of a metal in order to form an eutectic of metal and silicon between the case and the cover to be fixed upon the case. Advantageously, the coated layer is a gold layer as well as the conduction deposit inside the case. Thus, the material used for the main part and the cover, both being made of silicon, directly participates as a part of the gold-silicon eutectic (Au-Si) used for sealing the main part with the cover forming the case. As a non limitative variant, the gold layer can also be placed on the lid wafer (i.e. cover), and in that case the sides 14 forming the periphery of the case are not coated.

Referring now to Figure 5, it is a cut view of the case 12 represented in Figure 4 along the A-A axis. The main part 20 includes a bottom 13 and sides 14 forming the cavity 15. The gold deposits 21 connected to the outside via isolated silicon portions 23 obtained by the isolation structures 22 allow simple contacts with the resonator electrodes. In the example of a tuning-fork resonator with a central arm as shown in Figure 2, a bump 27 is advantageously provided with the bottom 13 in order to insure the necessary resonator elevation within the cavity to let it vibrates correctly. This can be easily done when the bump 27 is also made of silicon and can therefore be manufacture at the same time as the sides of the case. Another variant is to provide a gold bump, or a gold stud bump on the flat bottom of the case.

It is to be noted that an anti-diffusion layer 24 is advantageously coated on the sides of the main part 20 below the gold layer 25 coated on the upper faces of the sides 14 forming the periphery of the case. This is done in order to avoid massive needs of gold to form the silicon-gold eutectic with the adequate ratio need for sealing. Then the eutectic is obtained only through the gold layer 25 and the cover 26 shown in dotted lines. Conversely, if the anti-diffusion layer and the gold layer are deposited on the silicon lid 26, then the eutectic Au-Si is obtained only through the gold layer and the main part.

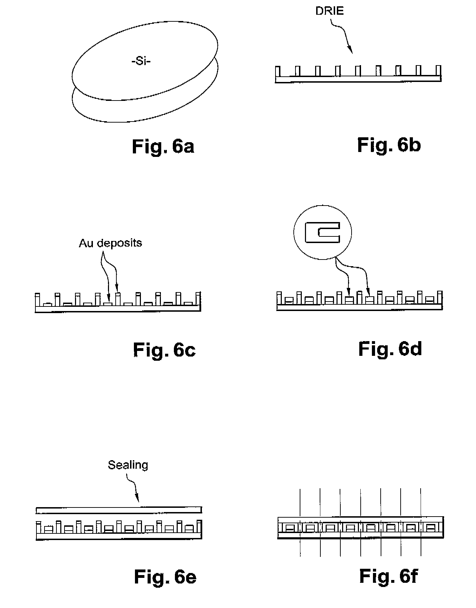

Figures 6a-6f are the steps of a serial manufacturing process of packages including piezoelectric resonators mounted inside cases according to a preferred embodiment of the invention. Figure 6a shows two silicon wafers needed as the basic material for the process. Figure 6b shows the step of forming in a first silicon wafer a predetermined number of hollowed main parts including a bottom and sides by a photolithographic process, and a silicon etching process, preferably DRIE. Figure 6c shows the step of coating portions of the main parts with metal-plated electrodes and coating upper faces of sides, where coatings are preferably made of gold. This step of gold coatings may be achieved either in one step or two steps. Figure 6d shows the step of mounting a piezoelectric resonator in each hollowed main parts in contact with the metal-plated electrodes. Figure 6e shows the step of forming in another silicon wafer, a cover for each hollowed main part and the step of assembling by sealing said predetermined number of hollowed main parts and said cover with an adequate eutectic of a metal and silicon, obtained with the metal coatings on upper faces of sides. Figure 6f shows the step of cutting adequately said first and second silicon wafers within sides of the main parts to form said predetermined number of packages including a piezoelectric resonator mounted inside. Anywhere during the manufacturing process an additional step may consists of isolating the metal plate electrodes by means of isolation structures passing through the first silicon wafer.

Thus, each package comprises a case entirely made of silicon, containing a cavity 15 capable to receive a quartz or piezoelectric resonator with, contact vias towards the outside.

Finally, the present invention also concerns a method for manufacturing a case for a piezoelectric resonator, comprising the steps of forming in a silicon substrate a main part including a bottom and sides by a photolithographic process; coating portions of the main part with metal-plated electrodes; forming in another silicon substrate a cover; assembling said main part and said cover with an adequate eutectic of a metal and silicon. This method further comprises the step of mounting a piezoelectric resonator in contact with the metal-plated electrodes prior to assembly the cover with the main part. Furthermore, it may be provided an additional step consisting in coating an anti-diffusion layer on the sides of the main part prior to its assembly with the cover, or on the cover.

Advantageously, the silicon substrate used to manufacture the cavity part can also be a SOI silicon wafer, taking advantage of the mid insulation layer for etch stop function or underlayer for the gold layer.

Having described the invention with regard to certain specific embodiments, it is to be understood that these embodiments are not meant as limitations of the invention. Indeed, various modifications, adaptations and/or combination between embodiments may become apparent to those skilled in the art without departing from the scope of the annexed claims.

## Claims

1. A case (10) for receiving a piezoelectric resonator (11), including a main part (12) with a bottom (13) and sides (14), in which said resonator shall be mounted and a cover (26) fixed to said main part closing said case, wherein the main part and the cover are both made of silicon.

2. The case according to claim 1, wherein the silicon main part is manufactured by using a photolithographic process.

3. The case according to claim 2, wherein the silicon main part is manufactured by using Deep Reactive Ion Etching.

4. The case according to claim 1, wherein a heat sealing is directly done between the cover and the main part by an adequate eutectic of a metal and silicon.

5. The case according to claim 4, wherein said adequate eutectic is an alloy of gold and silicon.

6. The case according to claim 5, wherein an anti-diffusion layer is coated on the sides of the main part below said eutectic.

7. The case according to claim 5, wherein an anti-diffusion layer is coated on the cover below said eutectic.

8. A package comprising a case according to any of the preceding claims and a piezoelectric resonator mounted in said case.

9. An assembly of two silicon wafers comprising a first wafer in which is manufactured a predetermined number of hollowed main parts for receiving piezoelectric resonators, each hollowed main part including a bottom and sides, in which a resonator shall be mounted, and a second wafer forming a cover for each hollowed main part, wherein the main parts and the covers forms a closed case.

10. A method for manufacturing a case for a piezoelectric resonator, comprising the steps of:
- forming in a silicon substrate a main part including a bottom and sides by a photolithographic process and silicon etching;
- coating portions of the main part with metal-plated electrodes;
- forming in another silicon substrate a cover;
- assembling said main part and said cover with an adequate eutectic of a metal and silicon.

11. The method of claim 10, wherein the silicon etching process used is Deep Reactive Ion Etching.

12. The method of claim 10, wherein it further comprises the step of mounting a piezoelectric resonator in contact with the metal-plated electrodes prior to assembly the cover with the main part.

13. The method of claim 10, wherein an anti-diffusion layer is coated on the sides of the main part below said eutectic.

14. The method of claim 10, wherein an anti-diffusion layer is coated on the cover below said eutectic.

15. A method for manufacturing packages including piezoelectric resonator mounted inside a case according to claim 1, comprising the steps of:
- forming in a first silicon wafer a predetermined number of hollowed main parts including a bottom and sides by a photolithographic process and silicon etching;
- coating portions of the main parts with metal-plated electrodes;
- mounting a piezoelectric resonator in each hollowed main parts in contact with the metal-plated electrodes;
- forming in another silicon wafer, a cover for each hollowed main part;
- assembling said predetermined number of hollowed main parts and said cover with an adequate eutectic of a metal and silicon;
- cutting adequately said first and second silicon wafers within sides of the main parts to form said predetermined number of packages including a piezoelectric resonator mounted inside.

16. The method of claim 15, wherein both first and second silicon wafer has the same size.
